# EUROPEAN PATENT SPECIFICATION

(11) **EP 0 248 789 B1**
(45) Date of publication and mention of the grant of the patent: **31.08.1994**
(21) Application number: 85905963.6
(22) Date of filing: 28.10.1985
(51) Int. Cl.: H03F 3/30

(54) **HIGH-FIDELITY AUDIO FREQUENCY AMPLIFIER**
HI-FI-TONFREQUENZVERSTÄRKER
AMPLIFICATEUR DE FREQUENCE ACOUSTIQUE DE HAUTE FIDELITE

(43) Date of publication of application: 16.12.1987
(73) Proprietor: SEGAL, Brahm, Torrance, CA 90501 (US)
(72) Inventor: SEGAL, Brahm, Torrance, CA 90501 (US)
(74) Representative: Coxon, Philip
(86) International application number: US8502140
(87) International publication number: WO8702844

(56) References cited:
- DE-A- 3 224 475
- US-A- 3 727 148
- AUDIO, vol. 64, no. 1, January 1980, pages 102-104,108, Philadelphia, US; L. FELDMAN: "DB systems model DB-6 stereo power amplifier"
- Tietze-Schenk Halbleiter-Schaltungstechnik, Ausgabe 1983, p. 495-496
- Hunter: Handbook of Semiconductors, 3rd ed. 1970, p. 11-38, 11-39

## Description

### Technical Field

This invention relates generally to audio frequency amplifiers, and particularly to a transformerless, high-fidelity, audio frequency amplifier.

### Background Art

There have been tremendous advances in the past 10 years or so in the design of high-fidelity audio frequency amplifiers, and some might say that near perfection has already been achieved. However, it seems that with each increment of improvement, new flaws are discovered, often not noticed until previously observed ones have been eliminated.

Perhaps one of the principal remaining areas of imperfection lies in the inability of perhaps most amplifiers to preserve at the output the precise time relationship between sounds of different frequencies which are embodied in the input signal to the amplifier. An excellent example of the problem is that of reproducing the fundamental and all of the harmonically related components coming from a musical instrument without some discrepancy in time of reproduction of the multitude of frequencies present (group delay).

It is the object of this invention to provide an amplifier which reduces the group delay in the time domain and in general improves the quality of reproduction and has a very large phase margin at the output stage.

The present invention distinguishes over the amplifier circuit which is the subject of DE-3224475 in the achievement of these objectives, and as specifically indicated in the characterising portion of the accompanying claims.

### Summary of the Invention

The above objects are achieved by the invention in accordance with claim 1. In the related amplifier, an input signal is first amplified in voltage by an operational amplifier. The signal is separated into positive and negative signal components for further and balanced amplification without the requirement of separate phase inversion stage. This is accomplished by using the ± bias ports of the operational amplifier as 180° phase reversed signal output sources. The positive port drives a positive polarity current amplification mirror, and the negative port drives a negative polarity current amplification mirror. The thus derived two, oppositely phased, current signals are then subjected to current regulation precisely in terms of the base emitter junctions which the signal must traverse thereafter in the amplifier. In this way, temperature variations which effect each junction may be summed in effect and compensated for, whereby variations in base-emitter junction impedance with temperature which may greatly affect the operating point of an amplifier are precisely compensated for. These and other features, as will be described, essentially eliminate time domain distortion effects currently observable with many amplifiers.

### Brief Description of the Drawings

Fig. 1 is an electrical schematic diagram of an embodiment of the invention.

Fig. 2 is a plan view illustrating the output amplifier stage of the invention, portions of which are shown schematically.

Fig. 3 is a side view of the output stage shown in Fig. 3.

### Detailed Description of the Invention

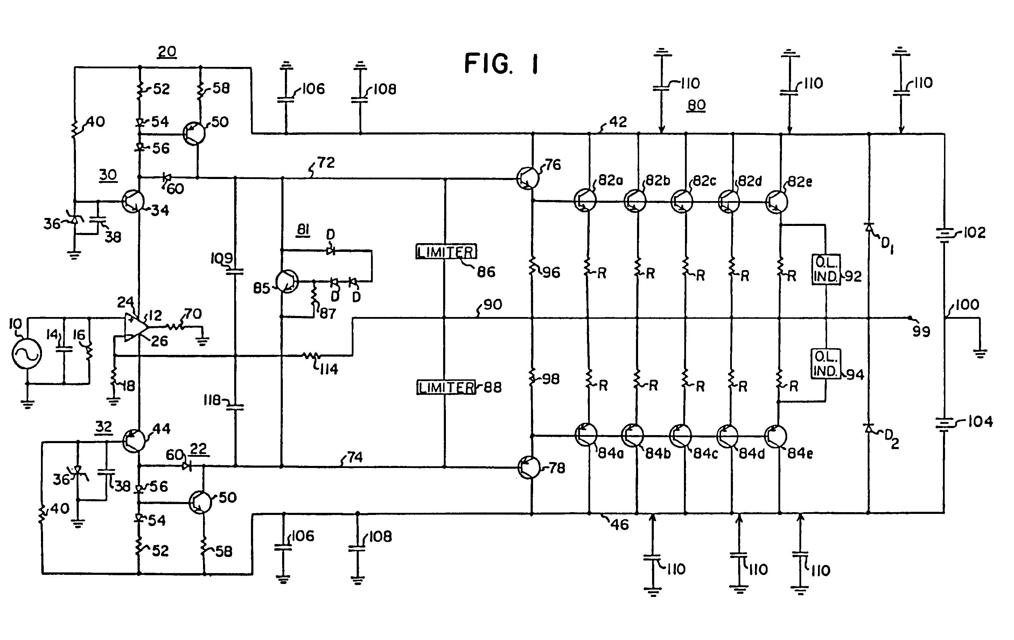

Referring initially to Fig. 1, a source 10 of audio frequency signals would be applied between the positive, or non-inverting, input of operational amplifier 12 and ground across a small capacitor 14, e.g., 30 PF, and resistor 16. This resistance-capacitance combination provides a rolloff of response above about 100KHz. The inverting input of the amplifier is connected across resistor 18 to ground. Operational amplifier 12 functions as a voltage amplifier, and the amplified voltage provides drive to current amplifiers or current mirrors 20 and 22 which mirror in terms of current the positive and negative voltage components of the input signal amplified by amplifier 12. Positive and negative components are separately provided to current amplifiers 20 and 22 by feeding an input to positive component current amplifier 20 from what would normally be the positive bias D.C. port 24 of an operational amplifier 12.

In order to provide a compatibility between operating bias levels, that for operational amplifier 12 of approximately 15 volts, and that for the bias level of the balance of the amplifiers at a significantly higher level, for example, 65 volts positive level shifter 30 is connected between positive bias port 24 of operational amplifier 12 and current amplifier 20, and negative potential level shifter 32 is connected between the negative bias port 26 and negative polarity current amplifier 22. As an example of the two, level shifter 30 employs NPN transistor 34 with its collector-emitter circuit between current amplifier 20 and operational amplifier 12 and a reference 15 volts applied to its base by virtue of a 15-volt zener diode 36, in parallel with capacitor 38, connected between ground and the base of resistor 34. The base is powered through bias resistor 40 from positive bias rail 42 (+65 volts). In this manner, the emitter of transistor 34, and thus the positive port 24 of operational amplifier 12, is held at essentially 15 volts, actually, 15 volts less the voltage drop (approximately 0.3 volt) across the base-emitter junction of transistor 34.

Level shifter 32 employs PNP transistor 44 and is coupled and operates in a like manner to that of level shifter 30 and includes like components which are like labeled. Its base is biased from negative bias rail 46 through resistor 40.

Of the two current amplifiers 20 and 22, current amplifier 20 employs PNP transistor 50, and there are two current paths between positive bias rail 42 and the collector of transistor 50, one path being via resistor 52, diode 54, and diode 56 in series, and the other being through emitter resistor 58, the emitter base circuit of transistor 50, and diode 60. With this configuration, the current amplification ratio between current through resistor 52 and the output of the circuit through resistor 52 is determined by the ratio of the values of resistor 52 (e.g. 300 ohms) and resistor 58 (e.g. 100 ohms), thus a ratio in this case of 3:1. Diode 54 is employed to provide a forward semi-conductor junction parallel to that of the emitter-base junction of transistor 50, and thus with like ambient temperatures, subject to both junctions, the voltage drops across each will be essentially identical, and thereby there is preserved impedance ratio between the two current paths, and thus there is stabily preserved the current amplification of the amplifier.

Diode 60 is connected between the collector of transistor 50 and the collector of transistor 34, poled for forward flow in the order of this connection, and diode 56 is connected, in a forward current flow mode between the base of transistor 50 and the collector of transistor 34. The purpose of these two diodes is to insure that the voltage at the base of transistor 50 will always be of a value less than the collector voltage of transistor 50; and, in fact, by virtue of these two diodes, the voltage at the base of transistor 50 will always be less by a value of at least the sum of the forward diode voltages of these two diodes. This prevents saturation cut-off and thus distortion effects that could occur in transistor 50.

Except that current amplifier 22 is coupled through level shifter 32 between negative bias rail 46 and negative bias port 26 of operational amplifier 12 and employs an NPN transistor, and thus current flow is opposite, the connections and operation of current amplifier 22 are identical to that of current amplifier 20.

The output of operational amplifier 12 is terminated by resistor 70, its function being merely to maintain a normal load on operational amplifier 12 (e.g., 400 to 600 ohms), and it is not employed as a signal output.

The signal varying output currents of current amplifier 20 and current amplifier 22 flow through signal bus leads 72 and 74 through base-emitter input circuits of NPN transistor amplifier 76 and PNP amplifier transistor 78, respectively, which function as drive amplifiers for power output stage 80. As a means of maintaining D.C. stability for the system and at an essentially constant operating point, a current regulator 81 is connected between signal buses 72 and 74. It employs an NPN transistor 85 conventionally (reversed biased) connected (collector-emitter) between these buses, and its impedence is regulated by a plurality of forward connected diodes D connected between bus 72 and the base of the transistor 85. Resistor 87 is connected between the base and emitter of transistor 85. The function of this regulator circuit is to compensate for ambient temperature produced changes in forward current flow to transistors 76 and 78 and beyond, this being effected by the regulator providing a shunt path which would reduce the drive level with increase in temperature to thus generally maintain a constant operating level. Three diodes D and the base-emitter junction of transistor 85 are employed to stimulate four base-emitter voltages which may vary with temperatures, these being: one represented by transistor 76; one represented by transistor 78; one represented by the parallel combination of power output transistors 82a, 82b, 82c, 82d and 82e; and one represented by the voltage drops across the parallel combination of power transistors 84a, 84b, 84c, 82d and 84e.

As a further circuit protective means, voltage limiters 86 and 88 are also connected to signal buses 72 and 74, voltage limiter 86 being connected between signal bus 72 and amplifier output bus 90, and voltage limiter 88 being connected between signal bus 74 and output bus 90. These limiters prevent the voltage at the input of transistors 76 and 78 from rising above a selected value and thereby overdriving the circuitry and possibly damaging it.

As a further protective feature, diodes D₁ and D₂ are connected in a reverse direction between the positive and negative rails and output bus. This prevents a voltage swing from an inductive load (a speaker) from raising the effective voltage applied to the output stage transistors above the applied biases plus the junction voltage drops of junctions of these diodes.

As a further protective feature, selected degrees of peak operating levels are indicated by means of a pair of overload indication circuits 92 and 94, one of each polarity of the output amplifier. Basically, these would be conventional adjustable peak voltage indicators. In some instances, it may be deemed acceptable to employ only one such indicator.

It is a particular feature of this invention that all of the transistors employed are high-frequency transistors and preferably having a cut-off no lower than 10 megacycles. Further, circuit layout is in accordance with RF (radio frequency) circuitry standards whereby stray capacitances and inductances are minimized.

The power output stage 80 of the present amplifier is a balanced amplifier wherein five NPN high-frequency transistors 82a-82e are connected in parallel between postive rail 42 and output bus 90 of small value (e.g. 0.33 ohm) resistors R being connected between the emitter of each and output bus 90. Similarly, five PNP transistors 84a-84e are connected in parallel between negative rail 46 and output bus 90 through like resistors R. The base inputs of transistors 82a-82e are fed from the emitter output of transistor 76 appearing across resistor 96 connected between its emitter and output bus 90. Similarly, the base inputs of transistors 84a-84e are fed from the emitter output of transistor 78 appearing across its emitter resistor 98 connected between the emitter of transistor 78 and output bus 90. By the employment of several high-frequency parallel transistors, it is possible to hold down the total capacitance or storage effects and thereby maintain excellent high-frequency operation.

The output of power output stage 80 appears between output bus terminal 99 and ground at terminal 100, the mid point for ± bias source 102 and 104 supply the ±65 volts to positive and negative rails 42 and 46. A loudspeaker would typically be connected across terminals 99 and 100. The power bias sources would typically comprise basic A.C. rectifier type power supplies (or a single supply), providing the ± bias voltages shown. The purity of these voltages is maintained by the employment of a plurality of filter capacitors for each polarity and the capacitors having different characteristics. Thus, in addition to having a basic high value capacitor 106, for example, of 100 MF for capacitor 106, there is also included capacitor 108 having a capacitance of 1 MF,and capacitors 110 having capacitances of 0.1 MF. Each has a low effective series of resistance. The resistance in each case would be chosen such that the inverse of the R-C time constant of that capacitor would be greater than all frequencies of interest. In this manner, it has been found that the power supply is quite flat insofar as it providing a very low impedance to all amplified frequencies. Actually, as will be noted, there are several capacitors having 0.1 MF capacitance.

As will be further noted, capacitors 110 are shown connected to the collector buses, or circuit board traces 42 and 46 via an arrow which is intended to indicate that the connection points are variable. In order to locate them, input signal 10 to the circuit is varied over a frequency of 20 Hz to 20 kHz and the effective load between output terminals 99 and 100 is varied through a range of resistive, capacitive and inductive loading thereby varying the power factor between about .1 and 1. When all this is done, certain combinations of frequencies and loads may generate spurious oscillations at the output of the amplifier at various output voltage levels. These will be accompanied by maximum voltage or high impedance points appearing along the collector buses 42 and 46. Then, one of the capacitors 110 is connected at each such voltage maximum point. By this system of connection, the spurious oscillations are essentially eliminated, enabling an extremely purer and stable output. As a matter of fact, the range of unaffected frequencies is easily from 10 Hz to 75 kHz.

Inverse feedback is provided from output terminal 99, back through resistor 114, and across resistor 18 to the inverting input of operational amplifier 12. Resistor 18 is approximately 1/22 of the value of resistor 114, and accordingly, this fraction of the output voltage is fed back to the inverting input of output voltage is fed back to the inverting input of operational amplifier 12. By virtue of the essentially absolute voltage-to-current mirror effect of the current amplifier 12, there is a negligibly small phase shift between operational amplifier 12 and the output of the amplifier. This enables a high degree of inverse feedback employed without the occurrence of instability. This, of course, enables the concurrent quite high effective damping effect on a speaker connected to the output of the amplifier to thus provide a very precise control of the speaker. The increased ability to provide higher inverse feedback also, of course, generally enables a lower distortion output of the amplifier.

As a further feature of the applicant's amplifier, small, 30 PF, inverse feedback capacitors 109 and 118 are connected from outputs of transistors 50 to the inverting input of operational amplifier 12. This enables a very low, less than 0.5% total harmonic distortion output without feedback from output stage 80. Likewise, there is enabled a high phase margin, and thus extreme stability, up to the megacycle range and up to a point where amplifier has unity gain. Actually, a high degree of inverse feedback is employed via resistor 114 as described above, the feedback providing a very high dampening factor (e.g., on the order of 500) and thus achieving a significantly reduced output impedance.

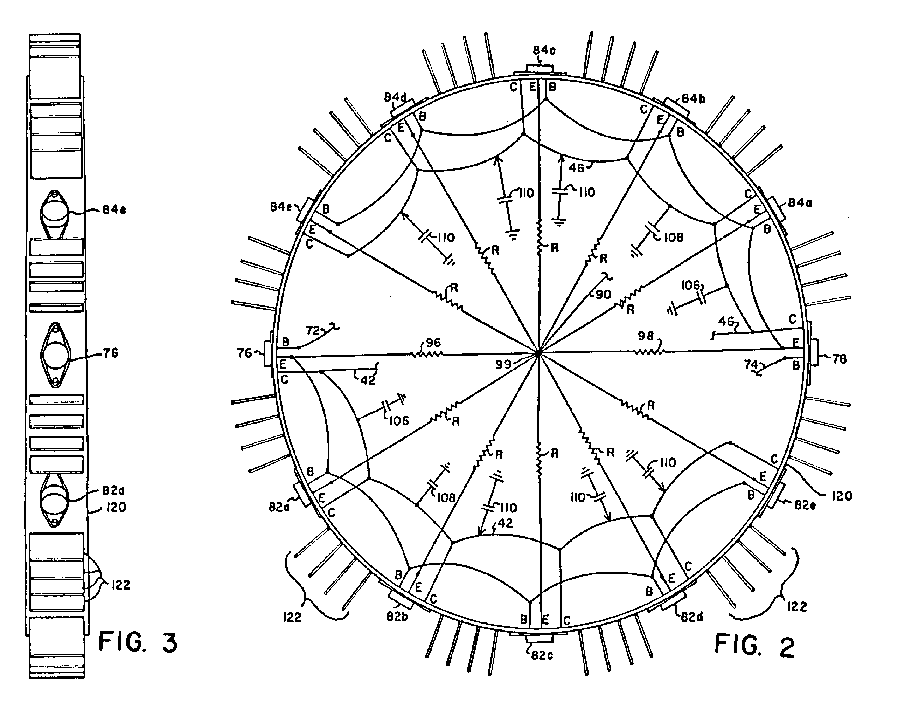

Figs. 2 and 3 illustrate, as one feature of this invention, a particular mechanical construction and arrangement of components for the output stage of applicant's amplifier. The output transistors 82a-82e and 84a-84e are mounted on a circular metal heat sink 120, having heat radiating fins 122 positioned between adjacent transistors. As one feature of this arrangement, the emitter leads are of identical length and are maintained as short as possible. This enables the distributed inductance, capacitance and resistance to be equal and thus load evenly shared by the transistors. Beyond this, the circular construction permits general symmetry of interconnections which enhances the operation of the amplifier.

By virtue of the total system of the invention as described and the fact that there is achieved essentially identical (and small) throughput delays of all frequencies, the amplifier provides an unusual degree of clarity and purity of reproduction. Thus, the relationship between harmonic frequencies and their fundamentals are maintained fixed, and sounds which may be rich in harmonics are faithfully reproduced. Beyond its employment for audio applications, the amplifier is ideally suited for a wide range of other applications, including industrial, space and military applications, anywhere a transducer must be driven by an amplified signal in accordance with the characteristics herein described.

## Claims

1. A high frequency/audio frequency amplifier comprising:
an input amplifier (12), having an inverting input, a non-inverting input, first and second input ports (24,26) for the supply current of said input amplifier and an output, the non-inverting input being a signal input;
a positive potential supply voltage source having a reference terminal (100) and a positive terminal (42);
a negative potential supply voltage source having a negative terminal (46) and a reference terminal (100) common with said reference terminal (100) of said positive potential supply voltage source;
a first current amplifier (20) having an input coupled between said positive terminal (42) and said first input port (24) of said input amplifier (12) and having a first current amplified output;
a second current amplifier (22) having an input coupled between said negative terminal (46) and said second input port (26) of said input amplifier (12) and having a second current amplified output;
a first transistor amplifying circuit comprising a first transistor (76), an amplifier output terminal (99), a first emitter resistor (98) connected to the emitter of said first transistor (76); and the output (72) of said first current amplifier (20) being connected as an input to the base of said first transistor (76) and the collector of said first transistor (76) being connected to said positive terminal (42);
a second transistor amplifying circuit comprising a second transistor (78) of opposite polarity type to said first transistor (76), a second emitter resistor (98) connected between the emitter of said second transistor (78), and the first emitter resistor and the output (74) of said second current amplifier (22) being connected as an input to the base of said second transistor (78);
a first power amplifier comprising at least one third transistor (82a) having its input connected to the emitter of said first transistor (76) and its collector connected to said positive terminal (42), and a third emitter resistor (R) connected between the emitter of said third transistor (82a) and said amplifier output terminal (99);
a second power amplifier comprising at least one fourth transistor (84a) of opposite polarity type to said third transistor (82a) and having its input connected to the emitter of said second transistor (78) and having its collector connected to said negative terminal (46), and a fourth emitter resistor (R) connected between the emitter of said fourth transistor (84a) and said amplifier output terminal (99), the combined outputs of said first and second power amplifiers appearing between said amplifier output terminal (99) and said reference terminal (100);
a temperature compensating current control (81) comprising a fifth transistor (85) connected in the emitter-to-collector configuration and between the bases of said first (76) and second (78) transistors, and current conducting means (D) connected from the base of one of said first (76) and second (78) transistors to the base of said fifth transistor (85),
a negative feedback circuit comprising a feedback resistor (114) connected between said amplifier output terminal (99) and said inverting input of said input amplifier (12), and characterised in that said negative feedback circuit further comprises a first capacitor (109) connected between the base of said first transistor (76) and the inverting input of said input amplifier (12), and a second capacitor (118) connected between the base of said second transistor (78) and the inverting input of said input amplifier (12); and said amplifier further includes
a plurality of capacitors (110) including a first plurality of capacitors (110) in turn including capacitors of different capacitances connected between said positive terminal (42) and said reference terminal (100), and a second plurality of capacitors (110), including capacitors of different capacitances connected between said negative terminal (46) and said reference terminal (100), wherein said plurality of capacitors includes capacitors connected to predetermined physical locations on said positive and negative terminals (42,46) at which there appears a voltage peak arising from a standing wave arising out of spurious oscillation.

2. An amplifier as set forth in claim 1 further comprising a first voltage level shifter (30) including a seventh transistor having its emitter coupled to said first input port (24) of said input amplifier (12), its collector coupled to said first current amplifier (20), and its base connected to said reference terminal (100) via coupling means (36,38), and a second voltage level shifter (32) including an eighth transistor having its emitter connected to the second input port (26) of said input amplifier (12), its collector coupled to said second current amplifier (22), and its base connected to said reference terminal (100) via coupling means (36,38).

3. An amplifier as set forth in claim 1 or claim 2 further comprising a first voltage limiter (86) connected between said amplifier output terminal (99) and the base of said first transistor (76), and a second voltage limiter (88) connected between said amplifier output terminal (99) and the base of said second transistor (78).

4. An amplifier as set forth in claim 3 further comprising a first diode (D1) connected in a reverse bias mode between said amplifier output terminal (99) and said positive terminal (42), and a second diode (D2) connected in a reverse bias mode between said amplifier output terminal (99) and said negative terminal (46).

5. An amplifier as set forth in claim 4 further comprising a first overload voltage indicator (92) connected between the emitter of said third transistor (82a-e) and said amplifier output terminal (99), and a second overload voltage indicator (94) connected between the emitter of said fourth transistor (84a-e) and said amplifier output terminal (99).

6. An amplifier as set forth in claim 1 wherein said input amplifier (12) is an operational amplifier, and wherein said current conducting means (D) comprise a plurality of serially connected diodes connected in a forward mode.

## Patentansprüche

1. Hochfrequenz/Tonfrequenzverstärker, umfassend:
einen Eingangsverstärker (12) mit einem invertierenden Eingang, einem nichtinvertierenden Eingang, ersten und zweiten Eingangsanschlüssen (24, 26) für den Speisestrom des Eingangsverstärkers sowie einem Ausgang, wobei der nichtinvertierende Eingang ein Signaleingang ist,
eine positive Potentialspeisespannungsquelle mit einer Referenz- oder Bezugsklemme (100) und einer Plusklemme (42),
eine negative Potentialspeisespannungsquelle mit einer Minusklemme (46) und einer mit der Bezugsklemme (100) der positiven Potentialspeisespannungsquelle gemeinsamen (zusammengeschalteten) Bezugsklemme (100),
einen ersten Stromverstärker (20) mit einem zwischen die Plusklemme (42) und den ersten Eingangsanschluß (24) des Eingangsverstärkers (12) geschalteten Eingang und mit einem ersten stromverstärkten Ausgang,
einen zweiten Stromverstärker (22) mit einem zwischen die Minusklemme (46) und den zweiten Eingangsanschluß (26) des Eingangsverstärkers (12) geschalteten Eingang und einem zweiten stromverstärkten Ausgang,
eine erste Transistorverstärkerschaltung aus einem ersten Transistor (76), einer Verstärkerausgangsklemme (99), (und) einem an den Emitter des ersten Transistors (76) angeschlossenen ersten Emitterwiderstand (98), wobei der Ausgang (72) des ersten Stromverstärkers (20) als ein Eingang an die Basis des ersten Transistors (76) und der Kollektor des ersten Transistors (76) an die Plusklemme (42) angeschlossen sind,
eine zweite Transistorverstärkerschaltung aus einem zweiten Transistor (78) des dem ersten Transistor (76) entgegengesetzten Polaritätstyp, (und) einem zwischen den Emitter des zweiten Transistors (78) und den ersten Emitterwiderstand geschalteten zweiten Emitterwiderstand (98), wobei der Ausgang (74) des zweiten Stromverstärkers (22) als ein Ausgang an die Basis des zweiten Transistors (78) angeschlossen ist,
einen ersten Leistungsverstärker mit mindestens einem dritten Transistor (82a), dessen Eingang mit dem Emitter des ersten Transistors (76) und dessen Kollektor mit der Plusklemme (42) verbunden sind, und mit einem zwischen den Emitter des dritten Transistors (82a) und die Verstärkerausgangsklemme (99) geschalteten dritten Emitterwiderstand (R),
einen zweiten Leistungsverstärker aus mindestens einem vierten Transistor (84a) des dem dritten Transistor (82a) entgegengesetzten Polaritätstyps, dessen Eingang an den Emitter des zweiten Transistors (78) und dessen Kollektor an die Minusklemme (46) angeschlossen sind, und einem zwischen den Emitter des vierten Transistors (84a) und die Verstärkerausgangsklemme (99) geschalteten vierten Emitterwiderstand (R), wobei die kombinierten Ausgangssignale der ersten und zweiten Leistungsverstärker zwischen der Verstärkerausgangsklemme (99) und der Bezugsklemme (100) auftreten,
einen Temperaturkompensierstromregler (81) aus einem in Emitter-Kollektor-Schaltung geschalteten und zwischen die Basen von erstem (76) und zweitem (78) Transistor eingeschalteten fünften Transistor (85) sowie von der Basis eines der ersten (76) und zweiten (78) Transistoren zur Basis des fünften Transistors (85) geschalteten Stromleitmitteln (D), (und)
eine negative Rückkopplungs- oder Gegenkopplungsschaltung aus einem zwischen die Verstärkerausgangsklemme (99) und den invertierenden Eingang des Eingangsverstärkers (12) geschalteten Rückkopplungswiderstand (114), dadurch gekennzeichnet, daß die Gegenkopplungsschaltung ferner einen zwischen die Basis des ersten Transistors (76) und den invertierenden Eingang des Eingangsverstärkers (12) geschalteten ersten Kondensator (109) und einen zwischen die Basis des zweiten Transistors (78) und den invertierenden Eingang des Eingangsverstärkers (12) geschalteten zweiten Kondensator (118) aufweist; und der Verstärker ferner umfaßt:
eine Anzahl von Kondensatoren (110) mit einer ersten Anzahl von Kondensatoren (110), die ihrerseits zwischen die Plusklemme (42) und die Bezugsklemme (100) geschaltete Kondensatoren verschiedener Kapazitäten beinhalten, und einer zweiten Anzahl von Kondensatoren (110) mit Kondensatoren verschiedener Kapazitäten, die zwischen die Minusklemme (46) und die Bezugsklemme (100) geschaltet sind, wobei die mehreren Kondensatoren (jeweils) Kondensatoren beinhalten, die an vorbestimmte physikalische Stellen an den Plus- und Minusklemme (42, 46) angeschlossen sind, an denen ein(e) Spannungspeak oder -spitze von einer stehenden Welle, die aus Störschwingung entsteht, auftritt.

2. Verstärker nach Anspruch 1, ferner umfassend einen ersten Spannungspegelschieber (30) mit einem siebten Transistor, dessen Emitter an den ersten Eingangsanschluß (24) des Eingangsverstärkers (12), dessen Kollektor an den ersten Stromverstärker (20) und dessen Basis an die Bezugsklemme (100) über Kopplungsmittel (36, 38) angeschlossen sind, und einen zweiten Spannungspegelschieber (32) mit einem achten Transistor, dessen Emitter an den zweiten Eingangsanschluß (26) des Eingangsverstärkers (12), dessen Kollektor an den zweiten Stromverstärker (22) und dessen Basis an die Bezugsklemme (100) über Kopplungsmittel (36, 38) angeschlossen sind.

3. Verstärker nach Anspruch 1 oder 2, ferner umfassend einen zwischen die Verstärkerausgangsklemme (99) und die Basis des ersten Transistors (76) geschalteten ersten Spannungsbegrenzer (86) und einen zwischen die Verstärkerausgangsklemme (99) und die Basis des zweiten Transistors (78) geschalteten zweiten Spannungsbegrenzer (88).

4. Verstärker nach Anspruch 3, ferner umfassend eine in einem Sperrichtungsmodus zwischen die Verstärkerausgangsklemme (99) und die Plusklemme (42) geschaltete erste Diode (D1) und eine in einem Sperrichtungsmodus zwischen die Verstärkerausgangsklemme (99) und die Minusklemme (46) geschaltete zweite Diode (D2).

5. Verstärker nach Anspruch 4, ferner umfassend einen zwischen den Emitter des dritten Transistors (82a-e) und die Verstärkerausgangsklemme (99) geschalteten ersten überlastspannungsanzeiger (92) und einen zwischen dem Emitter des vierten Transistors (84a-e) und die Verstärkerausgangsklemme (99) geschalteten zweiten Überlastspannungsanzeiger (94).

6. Verstärker nach Anspruch 1, wobei der Eingangsverstärker (12) ein Operationsverstärker ist und wobei die Stromleitmittel (D) eine Anzahl von in Reihe und in einem Durchlaßmodus geschalteten Dioden sind.

## Revendications

1. Amplificateur haute fréquence/basse fréquence comprenant :
un amplificateur d'entrée (12), ayant une entrée d'inversion, une entrée de non inversion, un premier et un second ports d'entrée (24, 26) pour le courant d'alimentation du dit amplificateur d'entrée et une sortie, l'entrée de non inversion étant une entrée de signal ;
une source de tension d'alimentation potentielle positive ayant une borne de référence (100) et une borne positive (42) ;
une source de tension d'alimentation potentielle négative ayant une borne négative (46) et une borne de référence (100) commune avec la dite borne de référence (110) de la dite source de tension d'alimentation potentielle positive ;
un premier amplificateur de courant (20) ayant une entrée couplée entre la dite borne positive (42) et le dit premier port d'entrée (24) du dit amplificateur d'entrée (12) et ayant une première sortie amplifiée de courant ;
un second amplificateur de courant (22) ayant une entrée couplée entre la dite borne négative (46) et le dit second port d'entrée (26) du dit amplificateur d'entrée (12) et ayant une seconde sortie amplifiée de courant ;
un premier circuit amplificateur à transistors comprenant un premier transistor (76), une borne de sortie d'amplificateur (99), une première résistance d'émetteur (98) reliée à l'émetteur du dit premier transistor (76) ; et la sortie (72) du dit premier amplificateur de courant (20) étant connectée comme entrée à la base du dit premier transistor (76) et le collecteur du dit premier transistor (76) étant relié à la dite borne positive (42) ;
un second circuit amplificateur à transistors comprenant un second transistor (78) de polarité opposée à celle du dit premier transistor (76), une seconde résistance d'émetteur (98) reliée entre l'émetteur du dit second transistor (78), et la première résistance d'émetteur et la sortie (74) du dit second amplificateur de courant (22) étant reliée comme entrée à la base du dit second transistor (78) ;
un premier amplificateur de puissance comprenant au moins un troisième transistor (82a) ayant son entrée reliée à l'émetteur du dit premier transistor (76) et son collecteur relié à la dite borne positive (42), et une troisième résistance d'émetteur (R) reliée entre l'émetteur du dit troisième transistor (82a) et la dite borne de sortie de l'amplificateur (99) ;
un second amplificateur de puissance comprenant au moins un quatrième transistor (84a) de polarité opposée à celle du troisième transistor (82a) et ayant son entrée reliée à l'émetteur du dit second transistor (78) et ayant son collecteur relié à la dite borne négative (46), et une quatrième résistance d'émetteur (R) reliée entre l'émetteur du dit quatrième transistor (84a) et la dite borne de sortie d'amplificateur (99), les sorties combinées des dits premier et second amplificateurs de courant apparaissant entre la dite borne de sortie d'amplificateur (99) et la dite borne de référence (100) ;
un contrôleur du courant de compensation de température (81) comprenant un cinquième transistor (85) relié selon la configuration émetteur-collecteur et entre les bases des dits premier (76) et second (78) transistors, et un moyen conducteur (D) relié depuis la base d'un des dits premier (76) et second (78) transistors à la base du dit cinquième transistor (85),
un circuit de contre-réaction comprenant une résistance de contre-réaction (114) reliée entre la dite borne de sortie d'amplificateur (99) et la dite entrée d'inversion du dit amplificateur d'entrée (12), et caractérisé en ce que le dit circuit de contre-réaction comprend en outre un premier condensateur (109) relié entre la base du dit premier transistor (76) et l'entrée d'inversion du dit amplificateur d'entrée (12), et un second condensateur (118) relié entre la base du dit second transistor (78) et l'entrée d'inversion du dit amplificateur d'entrée (12) ; et le dit amplificateur comprend en outre
une pluralité de condensateurs (110) comprenant une première pluralité de condensateurs (110) comprenant à leur tour des condensateurs de différentes capacitances reliés entre la dite borne positive (42) et la dite borne de référence (100), et une seconde pluralité de condensateurs (110), comprenant des condensateurs de différentes capacitances reliés entre la dite borne négative (46) et la dite borne de référence (100), où la dite pluralité de condensateurs comprend des condensateurs reliés aux emplacements physiques prédéterminés sur lesdites bornes positive et négative (42, 46) où apparaît une pointe de tension dépassant d'une onde stationnaire provenant d'une oscillation parasite.

2. Amplificateur selon la revendication 1 comprenant en outre un premier dispositif de déplacement du niveau de tension (30) comprenant un septième transistor ayant son émetteur couplé au dit premier port d'entrée (24) du dit amplificateur d'entrée (12), son collecteur couplé au dit premier amplificateur de courant (20), et sa base reliée à la dite borne de référence (100) via un moyen de couplage (36, 38), et un second dispositif de déplacement du niveau de tension (32) comprenant un huitième transistor ayant son émetteur relié au second port d'entrée (26) du dit amplificateur d'entrée (12), son collecteur couplé au dit second amplificateur de courant (22), et sa base reliée à la dite borne de référence (100) via un moyen de couplage (36, 38).

3. Amplificateur selon la revendication 1 ou la revendication 2 comprenant en outre un premier limiteur de tension (86) relié entre la dite borne de sortie de l'amplificateur (99) et la base du dit premier transistor (76), et un second limiteur de tension (88) relié entre la dite borne de sortie de l'amplificateur (99) et la base du dit second transistor (78).

4. Amplificateur selon la revendication 3 comprenant en outre une première diode (D1) connectée en polarisation inverse entre la dite borne de sortie de l'amplificateur (99) et la dite borne positive (42), et une seconde diode (D2) connectée en polarisation inverse entre la dite borne de sortie de l'amplificateur (99) et la dite borne négative (46).

5. Amplificateur selon la revendication 4 comprenant en outre un premier indicateur de tension en surcharge (92) connecté entre l'émetteur du dit troisième transistor (82a-e) et la dite borne de sortie de l'amplificateur (99), et un second indicateur de tension en surcharge (94) connecté entre l'émetteur du dit quatrième transistor (84a-e) et la dite borne de sortie de l'amplificateur (99).

6. Amplificateur selon la revendication 1 où le dit amplificateur d'entrée (12) est un amplificateur opérationnel, et où le dit moyen conducteur de courant (D) comprend une pluralité de diodes connectées en série connectées en mode direct.
